# EUROPÄISCHE PATENTSCHRIFT

(11) **EP 1 373 981 B1**
(45) Veröffentlichungstag und Bekanntmachung des Hinweises auf die Patenterteilung: **29.08.2007**
(21) Anmeldenummer: 02714195.1
(22) Anmeldetag: 28.03.2002
(51) Int. Cl.: G03F 7/20, G03H 1/08, G03F 1/08

(54) **Lithographische Vorrichtung mit bewegter Linse zum Herstellen digitaler Hologramme**
Lithographic apparatus with a mobile lens for producing digital holograms
Dispositif de lithographie à lentille mobile pour la formation d'hologrammes numériques

(30) Priorität: 30.03.2001 DE 10116059
(43) Veröffentlichungstag der Anmeldung: 02.01.2004
(73) Patentinhaber: tesa scribos GmbH, 69126 Heidelberg (DE)
(72) Erfinder: NOEHTE, Steffen, 69469 Weinheim (DE); DIETRICH, Christoph, 69126 Heidelberg (DE); THOMANN, Robert, 69121 Heidelberg (DE); STADLER, Stefan, 22359 Hamburg (DE); LEIBER, Jörn, 22529 Hamburg (DE)
(74) Vertreter: Rox, Thomas
(86) Internationale Anmeldenummer: PCT/EP2002/003517
(87) Internationale Veröffentlichungsnummer: WO 2002/079881

(56) Entgegenhaltungen:
- WO-A-00/72092
- WO-A-94/10684
- US-B1- 6 177 980

## Beschreibung

Die vorliegende Erfindung betrifft einen Lithographen (d.h. eine Lithographische Vorrichtung) zum Herstellen digitaler Hologramme in einem Speichermedium. Insbesondere weist der Lithograph eine Lichtquelle zum Erzeugen eines Schreibstrahls mit einem vorgegebenen Strahlquerschnitt, eine Schreiblinse zum Fokussieren des Schreibstrahls auf das zu beschreibende Speichermedium, wobei die Schreiblinse in einer Linsenhalterung angeordnet ist, und mit Antriebsmitteln zum zweidimensionalen Bewegen des Schreibstrahls relativ zum Speichermedium. Darüber hinaus betrifft die Erfindung ein Verfahren zum Herstellen digitaler Hologramme in einem Speichermedium.

Digitale Hologramme sind zweidimensionale Hologramme, die aus einzelnen Punkten mit unterschiedlichen optischen Eigenschaften bestehen und aus denen bei Beleuchtung mit einer kohärenten elektromagnetischen Welle, insbesondere Lichtwelle durch Beugung in Transmission oder Reflexion Bilder und/oder Daten reproduziert werden. Die unterschiedlichen optischen Eigenschaften der einzelnen Punkte können Reflexionseigenschaften beispielsweise durch Oberflächentopographie, variierende optische Weglängen im Material des Speichermediums (Brechungsindizes) oder Farbwerte des Materials sein.

Die optischen Eigenschaften der einzelnen Punkte werden von einem Computer berechnet, es handelt sich somit um sogenannte computergenerierte Hologramme (CGH). Mit Hilfe des fokussierten Schreibstrahls werden während des Schreibens des Hologramms die einzelnen Punkte des Hologramms in das Material eingeschrieben, wobei der Fokus im Bereich der Oberfläche oder im Material des Speichermediums liegt. Eine Fokussierung bewirkt im Bereich des Fokus eine geringe Einwirkungsfläche auf das Material des Speichermediums, so daß eine Vielzahl von Punkten des Hologramms auf einer kleinen Fläche geschrieben werden kann. Die optische Eigenschaft des jeweils geschriebenen Punktes hängt dabei von der Intensität des Schreibstrahls ab. Dazu wird der Schreibstrahl in zwei Dimensionen mit variierender Intensität über die Oberfläche des Speichermediums gescannt. Die Modulation der Intensität des Schreibstrahls erfolgt dabei entweder über eine interne Modulation der Lichtquelle, beispielsweise eine Laserdiode, oder über eine externe Modulation eines Schreibstrahls außerhalb der Lichtquelle, beispielsweise mit Hilfe von optoelektronischen Elementen. Darüber hinaus kann die Lichtquelle als gepulster Laser ausgebildet sein, dessen Pulslängen steuerbar sind, so dass über die Pulslängen eine Steuerung der Intensität des Schreibstrahls erfolgen kann.

Durch das Abscannnen des intensitätsmodulierten Schreibstrahls entsteht somit eine Fläche mit einer unregelmäßigen Punkteverteilung, das digitale Hologramm. Dieses kann zum Kennzeichnen und Individualisieren beliebiger Gegenstände eingesetzt werden.

Scannende lithographische Systeme sind an sich weit verbreitet. Beispielsweise werden scannende optische Systeme in herkömmliche Laserdrucker eingebaut. Diese Systeme können jedoch zur Herstellung von Hologrammen nicht eingesetzt werden, da sich die Anforderungen für diesen Anwendungszweck gegenüber denen bei Laserdruckern deutlich unterscheiden. Die Auflösung liegt bei guten Drucksystemen bei etwa 2500 dpi (etwa 10 µm), während bei der Herstellung von Hologrammen eine Auflösung von etwa 25.000 dpi (etwa 1 µm) erforderlich ist. Außerdem werden bei der digitalen Holographie nur vergleichsweise kleine Flächen beschrieben. Diese sind beispielsweise 1 bis 5 mm² groß, wobei auch andere Größen möglich sind. Die Genauigkeit des Schreibrasters muß bei einem Lithographen zur Herstellung digitaler Hologramme von beispielsweise 1000 x 1000 Punkten auf einer Fläche von 1 x 1 mm² etwa ± 0,1 mm in beide orthogonale Richtungen betragen. Darüber hinaus sollte die Schreibgeschwindigkeit etwa 1 Mpixel/s betragen, damit jeweils ein Hologramm in einer Zeit von ca. 1s geschrieben werden kann. Die vorgenannten. Größen sind beispielhaft und stellen keine Beschränkung der Erfindung dar.

Digitale Hologramme können mittels konventioneller Scanmethoden hergestellt werden, bei denen mit stehender Optik der Winkel des einfallenden Strahles variiert wird. Auf diesem Prinzip arbeiten beispielsweise Scanspiegellithographen mit Galvo- und Polygonscannern. Derartige Scanner haben jedoch den Nachteil, dass die Umsetzung dieses Prinzips mit einem hohen optischen und mechanischen Aufwand verbunden ist. Dieser Umstand setzt der Maximierung der Geschwindigkeit und der Auflösung optischer Lithographen enge Grenzen, da zu diesem Zweck Objektive benötigt werden, die einen großen Feldwinkel zulassen und den Ablenkwinkel vorzugsweise linear in eine x-Ablenkung in der Fokusebene des Objektives umsetzen ("F-Theta"-Objektive). Überdies müssen die verwendeten Objektive hinsichtlich der Bildwölbung korrigiert werden ("flat field"-Objektive), so dass aufwändige mehrteilige Optiken eingesetzt werden müssen, die einer kompakten Gestaltung des Lithographen entgegenstehen. Derartige komplexe Optiken stellen weiterhin hohe Ansprüche an die Mechanik des Lithographen, da diese relativ große Masse bewegen muss. Dieses ergibt sich auch daraus, dass es nicht möglich ist, beliebig kleine Scannspiegel zu wählen, da die Apertur des optischen Systems immer auch die Auflösung bestimmt.

Es sind jedoch auch scannende optische Systeme bekannt, bei denen die Scanbewegung nicht über einen bewegten Strahl, sondern über eine bewegte Optik erreicht wird. Aber auch hier werden nicht die Scangeschwindigkeiten und Genauigkeiten der Positionierung des Schreibstrahls erreicht, die es für die zu erreichenden Schreibgeschwindigkeiten ermöglichen, ein vorgegebenes Punktraster des digitalen Hologramms einzuhalten.

Die US 6,177,980 B1 offenbart ein lithographisches System bzw. ein Mikroskop, bei dem der gesamte Aufbau bestehend aus der Lichtquelle, der Kollimationsoptik und der Schreiblinse eine feste Einheit darstellt. Die Schreiblinsen bestehen aus einem Array von Mikrolinsen, die einzeln über eine digitale Mikrospiegelanordnung beleuchtet werden, so dass die Lichtintensität jedes Mikrospots durch das entsprechende Pixelelement der Mikrospiegelanordnung gesteuert wird. Der Wafer als Speichermedium wird unter dem ortsfesten Schreibstrahl bewegt, während die einzelnen pixel in ihrer Lichtintensität verändert werden. Dadurch entsteht ein Raster an Punkten auf dem Speichermedium.

Die aus der WO 00/72092 bekannte lithographische Vorrichtung weist ein optisches System auf, bei dem eine Vielzahl von Lichtleitern separat durch einzelne Lichtquellen gespeist werden und deren Lichtausgänge gemeinsam auf der Oberfläche des Speichermediums abgebildet werden. Jede der Lichtquellen erzeugt jeweils einen Punkt auf dem zu beschreibenden Speichermedium. Für eine Ortsveränderung des Schreibstrahls bzw. der Schreibstrahlen relativ zum Speichermedium ist ein Verschiebetisch vorgesehen, um das Speichermedium bzw. das Substrat in zwei senkrecht zueinander verlaufende Richtungen zu verschieben.

Die Druckschrift WO 94/10684 offenbart schließlich ein Verfahren zum Beschreiben einer sich drehenden Scheibe. Auch hier bewegt sich das Speichermedium durch eine Drehbewegung der Scheibe relativ zum Schreibstrahl, während der optische Aufbau zur Erzeugung des Schreibstrahls an sich eine feste Einheit bildet.

Der vorliegenden Erfindung liegt daher das technische Problem zugrunde, mittels optischer Lithographie computergenerierte Hologramme möglichst schnell und mit geringem Aufwand zu schreiben.

Das zuvor aufgezeigte technische Problem wird gemäß einer ersten Lehre der Erfindung durch einen Lithographen mit den Merkmalen des Anspruches 1 gelöst.

Somit werden mit dem erfindungsgemäßen Lithographen die digitalen Hologramme mittels einer Scanbewegung des Schreibstrahls in einer ersten Bewegungsrichtung erzeugt, die durch eine bewegte Optik realisiert wird. Dieses beruht auf dem Prinzip, dass sich der Fokuspunkt einer Linse in fester Relation zu ihr mitbewegt, wenn die Linse senkrecht zu einem, vorzugsweise gut kollimierten Strahl bewegt wird. Besitzt der Strahl eine hinreichend flache Wellenfront und ist sein Querschnitt größer als die Apertur der Linse, so lässt sich durch Bewegung der Linse eine Scanbewegung des Fokus erzielen, ohne dass ortsabhängige Schwankungen der Strahlintensität im Fokuspunkt auftreten.

Diese Lösung bietet den Vorteil, eine Scanbewegung mit hoher Geschwindigkeit zu ermöglichen, ohne dass große Massen bewegt werden müssen. Die zu bewegende Masse ist gegenüber dem Stand der Technik reduziert, da nur noch die Schreiblinse bewegt wird, nicht aber zusätzlich mindestens ein weiterer Spiegel einschließlich dessen Halterung.

Eine hohe Geschwindigkeit der Scanbewegung bedeutet in diesem Zusammenhang eine Schwingungsrate im Bereich von 1 kHz. Denn das Hologramm, das beispielsweise 1000 x 1000 Punkte umfasst, soll in einer Sekunde geschrieben werden, so dass in der ersten Bewegungsrichtung 1000 Zeilen mit jeweils 1000 Punkten geschrieben werden. Es kommt also zu einer hohen Zahl von Richtungswechseln.

Der zur Herstellung digitaler Hologramme zu scannende Bereich ist typischerweise 1 bis 5 mm² groß und ist somit deutlich kleiner als die Apertur einer typischen Objektivlinse. Unter einer typischen Objektivlinse wird hierbei eine Linse verständen, die eine numerische Apertur (NA) von vorzugsweise 0,4 oder mehr, eine Apertur von vorzugsweise 4 bis 6 mm und ein Gewicht von weniger als einem Gramm besitzt. Derartige Linsen werden bereits für CD- und DVD-Laufwerke verwendet und können als asphärische Singlets preiswert hergestellt werden. Die bei der vorliegenden Erfindung vorzugsweise verwendete Schreiblinse unterscheidet sich aber von diesen Linsen in der Deckglasdickenkorrektur, die auf den jeweiligen Anwendungszweck abgestimmt sein muss.

Nachstehend wird die Erfindung anhand bevorzugter Ausführungsformen ausführlicher erläutert.

In bevorzugter Weise ist die Antriebsvorrichtung als Linearmotor oder als Voice-Coil-Motor ausgebildet. Beide Antriebe sind dazu geeignet, die hohen Scangeschwindigkeiten bzw. Schwingungsraten der Linsenhalterung zu erzeugen.

Die Lagerung der Linsenhalterung erfolgt bevorzugt mit Festkörpergelenken. Somit können die Linsenhalterung und damit die Schreiblinse in der ersten Bewegungsrichtung resonant schwingen, vorzugsweise mit einer Frequenz, die größer als 1 kHz ist. Anstelle der Festkörpergelenke sind auch andere Lagerungen der Linse möglich, beispielsweise verspannte Kugellager, Gleitlager, Luftlager oder Magnetlager. Diese haben jedoch gegenüber der bevorzugten Lagerung mit Festkörpergelenken den Nachteil, dass sie einen höheren Verschleiß oder einen höheren technischen Aufwand bedingen. Wesentlich bei der Gestaltung der Lagerung ist, dass die Linse mit hoher Präzision gelagert ist. Dabei muß die Wegabweichung seitlich zur Bewegungsrichtung kleiner als 0,2 mm sein und in Strahlrichtung maximal 0,5 mm betragen. Auch die Verkippung der Linse muss sehr gering sein, da sonst die Qualität des Fokuspunktes nicht gesichert ist.

Die scannende Bewegung der Schreiblinse kann je nach der Art der Lagerung linear oder drehend ausgelegt sein. Bei einer linearen Scanbewegung entsteht eine lineare Belichtungsspur auf dem Speichermedium, während bei einer Scanbewegung um eine Drehachse jeweils Kreisbögen durchlaufen werden. Ist der Radius ist diesem Fall groß gegen die Länge der Scanbewegung, so kann in guter Näherung ein gerader Verlauf der Scanbewegung angenommen werden. In jedem Fall lässt sich der gekrümmte Verlauf der Scanbewegung rechnerisch beim Erzeugen des computergenerierten Hologramms berücksichtigen, indem die von einem orthogonalen Raster abweichende Punkteanordnung zugrunde gelegt wird.

Die Lagerung der Schreiblinse in der dargestellten.Weise erlaubt die Bewegung der Linse in nur einer Richtung. Da zur Herstellung zweidimensionaler digitaler Hologramme jedoch Arrays belichtet werden, ist eine weitere scannende Bewegung in einer zweiten Richtung durch die Antriebsmittel erforderlich. Diese Querbewegung weist eine zur ersten Bewegungsrichtung senkrechte Komponente auf, insbesondere verläuft diese im wesentlichen senkrecht zur ersten Bewegungsrichtung.

Eine Bewegung quer zu der Bewegung der Schreiblinse wird erreicht, indem eine zweite Antriebsvorrichtung zum Bewegen des Schreibstrahls relativ zum Speichermedium in einer zweiten Bewegungsrichtung quer zur ersten Bewegungsrichtung vorgesehen ist. Das Erzeugen dieser relativen Querbewegung ist in verschiedener Weise möglich.

In einer ersten bevorzugten Weise bewegt die zweite Antriebsvorrichtung die Linsenhalterung der Schreiblinse relativ zum Schreibstrahl. Zweitens kann die zweite Antriebsvorrichtung die Lichtquelle, die Kollimationsoptik und die Linsenhalterung der Schreiblinse relativ zum Speichermedium bewegen. Drittens kann die zweite Antriebsvorrichtung das Speichermedium selbst relativ zur Lichtquelle, Kollimationsoptik und Schreiblinse bewegen. In jedem der zuvor beschriebenen Fälle wird eine Relativbewegung zwischen Schreibstrahl und Speichermedium erzeugt, die quer, insbesondere senkrecht zur ersten Bewegungsrichtung der Schreiblinse erfolgt. Diese Bewegung entlang der zweiten Bewegungsrichtung erfolgt ebenfalls mit hoher Präzision. In Abhängigkeit von der konkreten Anwendung ist im allgemeinen die Ausgestaltung bevorzugt, die mit der geringsten zu bewegenden Masse verbunden ist.

Des weiteren kann die Schreiblinse als Mikrolinse ausgebildet sein. Die Mikrolinse weist eine räumliche Dimension, insbesondere einen Durchmesser im wesentlichen in der Größenordnung des zu erzeugenden Hologramms auf.

Die Dimension der digitalen Hologramme liegt bei der vorliegenden Erfindung im Bereich von 1 bis 5 mm. Durch die geringe Größe der Schreiblinse wird das zu bewegende Gewicht des Lithographen verringert, so dass entweder der Antrieb zum Erzeugen der Relativbewegungen zwischen dem Schreibstrahl und dem Speichermedium weniger aufwändig zu sein braucht oder höhere Schreibgeschwindigkeiten erreicht werden können. Durch die Verwendung von Mikrolinsen verringert sich zudem der Abstand zwischen dem Lithographen und dem Speichermedium, so dass der gesamte Aufbau aus Lithographen und Speichermedium verkleinert wird.

In weiter bevorzugter Weise sind mindestens zwei Schreiblinsen nebeneinander angeordnet, wobei der Schreibstrahl gleichzeitig die mindestens zwei Schreiblinsen ausleuchtet. Sind mehr als zwei Schreiblinsen vorgesehen, so sind dies bevorzugt in Form eines Arrays angeordnet. Wird dann der Schreibstrahl relativ zum Speichermedium bewegt, so erfolgt die Bewegung der durch die einzelnen Mikrolinsen durchgelassenen, fokussierten Teilstrahlen parallel zueinander. Somit können entsprechend der Mehrzahl von Schreiblinsen gleichzeitig mehrere Hologramme in ein Hologrammarray geschrieben werden. Lediglich die Intensität des Schreibstrahls muss entsprechend vergrößert werden, wobei sich die jeweiligen Intensitäten auf alle Teilstrahlen gleichermaßen auswirken.

Das parallele Schreiben einer Mehrzahl von identischen Hologrammen in Form eines Hologrammarrays weist den Vorteil auf, dass eine geringere Ausleuchtungsintensität für ein anschließendes Rekonstruieren des Hologramms erforderlich ist. Denn der Lesestrahl trifft gleichzeitig auf die Mehrzahl von identischen Hologrammen, wodurch entsprechend häufig dasselbe Hologramm erzeugt wird. Diese Einzelhologramme vereinen sich zu einem gesamten Hologramm mit einer gegenüber der einzelnen Intensität verstärkten Intensität.

Die Mikrolinse an sich sowie das Array von Schreiblinsen in Form der Mikrolinsen lässt sich insbesondere vorteilhaft bei dem oben beschriebenen Lithographen mit bewegter Schreiblinse anwenden. Denn das geringe Gewicht der einzelnen Schreiblinsen ermöglicht eine schnelle Scanbewegung. Im Falle eines Arrays von Schreiblinsen sind diese gemeinsam in der Linsenhalterung angeordnet, die von der ersten Antriebsvorrichtung und ggf. der zweiten Antriebsvorrichtung bewegt wird. Sämtliche weiter oben beschriebene vorteilhafte Ausgestaltungen lassen sich somit auch mit Mikrolinsen bzw. Arrays von Mikrolinsen kombinieren.

Das oben aufgezeigte technische Problem wird weiterhin erfindungsgemäß durch ein Verfahren zum lithographischen Erzeugen eines digitalen Hologramms in einem Speichermedium mit den Merkmalen des Anspruches 14 gelöst, wobei ein Schreibstrahl mit Hilfe einer Lichtquelle und einer Schreiblinse auf das Speichermedium fokussiert und mit Hilfe von Antriebsmitteln zweidimensional relativ zum Speichermedium bewegt wird, bei dem die Schreiblinse in einer ersten Bewegungsrichtung im wesentlichen senkrecht zur Ausbreitungsrichtung des Schreibstrahls relativ zum optischen Speichermedium bewegt wird, bei dem innerhalb des Bewegungsbereiches der Schreiblinse die Apertur der Schreiblinse vom Schreibstrahl im wesentlichen vollständig ausgeleuchtet wird und bei dem das Hologramm durch punktweises Einbringen von Strahlungsenergie geschrieben wird, wobei die Intensität des Schreibstrahls in Abhängigkeit von der Position des Schreibstrahls auf dem Speichermedium gesteuert wird. In Abhängigkeit von der Intensität des Schreibstrahls werden dadurch punktweise die optischen Eigenschaften des Materials des Speichermediums verändert.

Dabei wird der Schreibstrahl zusätzlich in einer zweiten Bewegungsrichtung quer zur ersten Bewegungsrichtung relativ zum Speichermedium bewegt. Dazu gibt es die bereits oben anhand des Aufbaus des Lithographen erläuterten Möglichkeiten. Bei einer ersten Ausführungsform wird die Schreiblinse in einer zweiten Bewegungsrichtung quer zur ersten Bewegungsrichtung relativ zum Speichermedium bewegt. Zweitens können die Lichtquelle und die Schreiblinse zusammen relativ zum Speichermedium bewegt werden. Und drittens kann das Speichermedium selbst relativ zur Lichtquelle und Schreiblinse bewegt werden. Durch die Überlagerung der Bewegungen entlang der beiden Bewegungsrichtungen ergibt sich ein zweidimensionales Scannen des Schreibstrahls über die Oberfläche des Speichermediums, wodurch der Schreibvorgang des Hologramms durchgeführt wird.

Bei einer weiteren Ausführungsform der vorliegenden Erfindung wird mit Hilfe des Schreibstrahls ein orthogonales Punktraster auf dem Speichermedium abgescannt. Mit anderen Worten laufen beide Scanbewegungen so ab, dass der von der Schreiblinse fokussierte Schreibstrahl ein orthogonales Punktraster auf dem optischen Speichermedium überfahren. Dabei hängt die Qualität des geschriebenen Hologramms davon ab, dass das Schreibraster möglichst genau abgescannt wird.

Dieses wird vorzugsweise dadurch erreicht, dass während der schwingenden Bewegung der Schreiblinse in der ersten Bewegungsrichtung mit hoher Geschwindigkeit, also entlang der sog. schnellen Achse, keine Bewegung quer zu dieser Bewegung erfolgt, solange das optische Speichermedium beschrieben wird. Schwingt die Schreiblinse dann zurück ohne das Speichermedium zu beschreiben, so wird die Schreiblinse relativ zu dem zu beschreibenden Speichermedium um einen Schritt in der zweiten Bewegungsrichtung, also entlang der sog. langsamen Achse, bewegt. Die Schreiblinse verbleibt danach bezüglich der zweiten Bewegungsrichtung in dieser Position, bis wiederum der schreibende Bewegungsabschnitt der Schreiblinse auf der schnellen Achse ausgeführt ist und die Schreiblinse erneut zurückschwingt. Die Bewegung auf der langsamen Achse erfolgt somit diskontinuierlich und die beiden Bewegungen müssen genau aufeinander abgestimmt und geregelt sein. Mit anderen Worten findet das Beschreiben des Speichermediums nur in der Hinbewegung entlang der schnellen Achse statt, während auf der Rückbewegung das Verstellen des Schreibstrahls quer dazu erfolgt.

Ebenso ist es möglich, sowohl während der Hinbewegung als auch bei der Rückbewegung das Speichermedium zu beschreiben und das Querverstellen während der Umkehrbewegung in der ersten Bewegungsrichtung durchzuführen.

Um diesen Anforderungen in bezug auf das zu schreibende Hologramm gerecht zu werden, sollte die Schreiblinse auf der schnellen Achse mit einer Frequenz von etwa 1 kHz schwingen, während die diskontinuierliche Verschiebung der Schreiblinse in bezug auf das Medium auf der langsamen Achse, das heißt quer zu der schwingenden Bewegung, innerhalb von 0,3 bis 0,6 ms erfolgen sollte. Der Schreibtrigger für eine Modulation der Intensität des Schreibstrahls muss dabei in einer Größenordnung von mehreren Megahertz ablaufen.

Alternativ dazu kann die Bewegung der Schreiblinse in der zweiten Bewegungsrichtung auf der langsamen Achse kontinuierlich erfolgen. Das hat dann jedoch zur Folge, dass die Schreibpunkte nicht mehr auf einem orthogonalen Raster liegen. Dies kann jedoch durch eine entsprechende Gestaltung der Steuerung, bspw. durch eine entsprechend ausgebildete Software kompensiert werden.

Die zuvor beschriebene Funktionsweise der vorliegenden Erfindung sowie deren bevorzugte Ausgestaltungen können auch in vorteilhafter Weise bei einem scannenden, insbesondere konfokalen Mikroskop eingesetzt werden. Bei einem derartigen Mikroskop wird die zu untersuchende Oberfläche mit einem Lichtstrahl abgetastet bzw. beobachtet und die reflektierte Lichtintensität wird gemessen. Während des Abtastens der Oberfläche wird dann das Bild aus den gemessenen Intensitäten des reflektierten Lichts zusammengesetzt. Die Oberfläche wird also in einem Raster abgetastet, wie es zuvor beschrieben worden ist.

Vorliegend wird dazu im Strahlengang des reflektierten Strahls vor oder bevorzugt hinter der bewegten Linse ein Strahlteiler angeordnet, um die reflektierte Strahlung auf einen optischen Sensor zu leiten. Dieser misst die reflektierte Intensität.

Mit einem Mikroskop gemäß Anspruch 24 wird das technische Problem gelöst, eine Oberfläche möglichst schnell und mit geringem Aufwand abzutasten. Dieses steht im Einklang mit dem dem zuvor beschriebenen Lithographen zugrundeliegenden technische Problem. Die zuvor für den Lithographen beschriebenen Vorteile werden ebenfalls bei einem derartigen Mikroskop erreicht.

Die Erfindung wird im folgenden nur beispielsweise anhand der Zeichnungen beschrieben. Dabei zeigt:
- Fig. 1: ein erstes Ausführungsbeispiel eines erfindungsgemäßen Lithographen in einer Seitenansicht,
- Fig. 2: den Lithographen im Querschnitt entlang der Linie II-II in Fig. 1, wobei die Linsenhalterung und der Linearantrieb in einer Draufsicht dargestellt sind,
- Fig. 3: ein zweites Ausführungsbeispiel einer Antriebsvorrichtung zum Bewegen der Schreiblinse,
- Fig. 4: ein zweites Ausführungsbeispiel eines erfindungsgemäßen Lithographen mit einer Anordnung von mehreren Schreiblinsen,
- Fig. 5: den Lithographen im Querschnitt entlang der Linie V-V in Fig. 4, wobei die Linsenhalterung und der Linearantrieb in einer Draufsicht dargestellt sind und
- Fig. 6: ein erfindungsgemäßes Mikroskop mit einem Aufbau, der im wesentlichen dem Aufbau des in Fig. 1 dargestellten Lithographen entspricht.

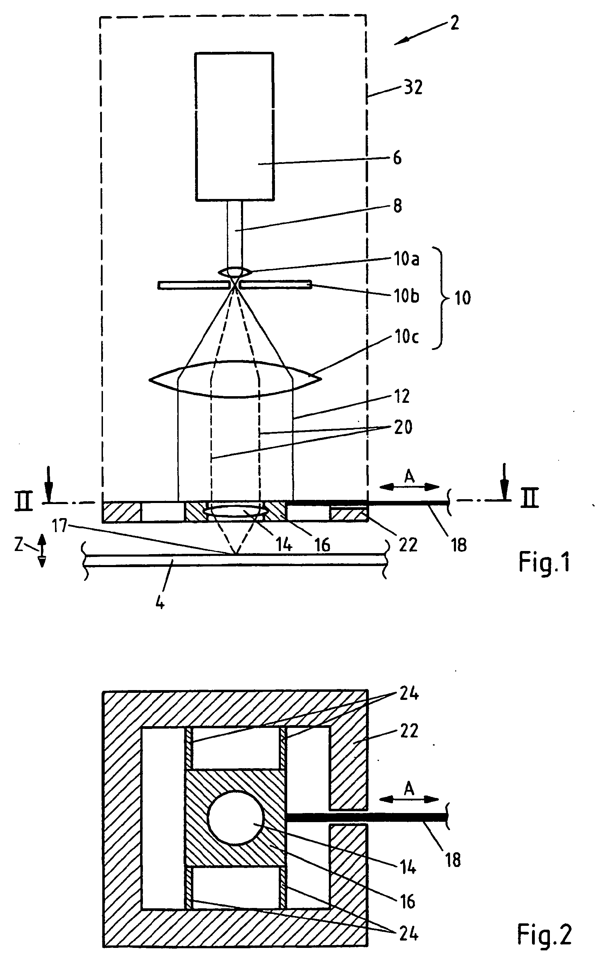

In den Fig. 1 und 2 ist ein erstes Ausführungsbeispiel eines erfindungsgemäßen Lithographen 2 zum Herstellen digitaler Hologramme in einem Speichermedium 4 dargestellt. Dieser weist einen Laser 6 zum Erzeugen eines Schreibstrahls 8 auf, der mit einer Kollimationsoptik 10 zum Aufweiten und Kollimieren des Laserstrahls 8 auf einen vorgegebenen Strahlquerschnitt aufgeweitet wird. Dazu besteht die Kollimationsoptik 10 aus einer ersten fokussierenden Linse 10a mit kleiner Brennweite, einer Lochblende 10b und einer fokussierenden Linse 10c, die als räumlicher Frequenzfilter für eine weitgehende Strahlhomogenisierung angeordnet sind. Der Laserstrahl 8 verlässt die Kollimationsoptik 10 als aufgeweiteter Schreibstrahl 12. Die Einheit aus Laser 6 und Kollimationslinse 10 stellt also die Lichtquelle zum Erzeugen des Schreibstrahls 12 dar.

Weiterhin weist der Lithograph 2 eine Schreiblinse 14 zum Fokussieren des kollimierten Schreibstrahls 12 auf das zu beschreibende Speichermedium 4 auf. Die Schreiblinse 14 ist dazu in einer Linsenhalterung 16 angeordnet, wie insbesondere auch in Fig. 2 dargestellt ist.

Durch die Schreiblinse 14 wird der Schreibstrahl 12 in einem Fokuspunkt 17 auf der Oberfläche des . Speichermediums 4 gebündelt. Dadurch kommt es zu einer Wechselwirkung zwischen dem Schreibstrahl und dem Material des Speichermediums, wodurch lokal in dem Bereich des Fokuspunktes die optische Eigenschaft des Materials verändert wird, sofern die Intensität des Schreibstrahls ausreichend ist.

Zum Bewegen der Linsenhalterung 16 im wesentlichen senkrecht zum kollimierten Schreibstrahl 12 ist eine erste Antriebsvorrichtung vorgesehen, wobei die Antriebsvorrichtung nur zum Teil in Form eines Steges 18 dargestellt ist. Der Steg ist mit einem Linearantrieb verbunden, der eine durch den Doppelpfeil A gekennzeichnete oszillierende Bewegung ausführt. Durch die Bewegung der Linsenhalterung 16 und somit der Schreiblinse 14 verschiebt sich der Fokuspunkt 17 der Schreiblinse entsprechend auf der Oberfläche des. Speichermediums 4. Je nach Auslenkung der Linsenhalterung 16 werden somit andere Bereiche der Oberfläche des Speichermediums 4 erreicht.

Wie Fig. 1 weiterhin zeigt, ist die Apertur der Schreiblinse 14 kleiner als der Strahlquerschnitt des aufgeweiteten und kollimierten Schreibstrahls 12. Somit wird nur ein Teil des aufgeweiteten Schreibstrahls 12 durch die Schreiblinse 14 fokussiert. Dieser Teil des Schreibstrahls 12 ist mit den gestrichelten Linien 20 dargestellt. Wenn nun die Linsenhalterung 16 durch die Antriebsvorrichtung 18 verstellt wird, so befindet sich die Schreiblinse 14 jeweils vollständig innerhalb des vom aufgeweiteten Schreibstrahl 12 ausgeleuchteten Bereiches. Dadurch wird gewährleistet, dass in jedem Punkt der Bewegung der Schreiblinse 14 ein gleicher Anteil des Schreibstrahls 12 fokussiert wird. Eine gleichbleibende Strahlintensität im Fokus ist somit die Folge.

Der lineare Antrieb, der den Steg 18 bewegt, kann beliebig ausgebildet sein. Bevorzugt sind als Antriebsvorrichtung ein magnetischer Linearmotor oder ein Voice-Coil-Motor. Als Lagerung der Linsenhalterung 16 gegenüber dem Rahmen 22 dienen im dargestellten Beispiel Festkörperlager 24. Ebenso können als Lager verspannte Kugellager, Gleitlager, Luftlager oder Magnetlager eingesetzt werden.

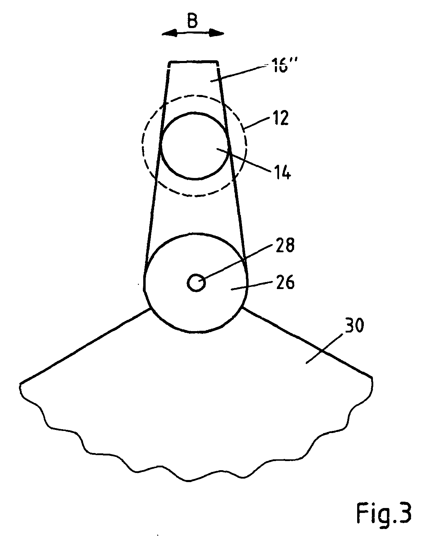

Fig. 3 zeigt ein weiteres Beispiel einer Lagerung und eines Antriebes der Linsenhalterung 16''. Es ist ein Drehlager 26 vorgesehen, um dessen Drehachse 28 die als Arm ausgebildete Linsenhalterung 16" in einer Drehrichtung (Pfeil B) resonant schwingt. Als Antrieb dient ein quasilinearer, einen Teil kreissegment abdeckender Antrieb 30 dargestellt ist. Dieser Linearantrieb ist aus dem Stand der Technik der Lesekopfantriebe für Computerfestplatten bekannt. Jedenfalls kann durch einen derartigen Linearmotor 48 aufgrund der geringen Masse und des starken Antriebes eine oszillierende Bewegung der Linsenhalterung 16' ' im Bereich von 5-10 kHz erzeugt werden.

Anhand der Fig. 1 bis 3 ist bisher nur die Bewegung der Schreiblinse 14 relativ zum Speichermedium 4 in der ersten Bewegungsrichtung dargestellt worden. Um ein zweidimensionales digitales Hologramm zu schreiben ist eine weitere Bewegung in einer zweiten Bewegungsrichtung, vorzugsweise senkrecht zur ersten Bewegungsrichtung notwendig.

In den Fig. 1 und 2 verläuft die erste Bewegungsrichtung horizontal, wie mit dem Pfeil A dargestellt ist. Die zweite Bewegungsrichtung verläuft dagegen senkrecht zur Zeichenebene der Fig. 1 bzw. vertikal in Fig. 2. Wie oben bereits beschrieben worden ist, gibt es verschiedene Möglichkeiten, die Bewegung des Schreibstrahls 12 relativ zum Speichermedium 4 zu realisieren. Dazu ist eine zweite Antriebsvorrichtung vorgesehen, die nicht gesondert in den Figuren dargestellt ist. Die Ausgestaltung dieser zweiten Antriebsvorrichtung kann ähnlich wie die erste Antriebsvorrichtung sein, jedoch sind keine so hohen Anforderungen an die Schnelligkeit des zweiten Antriebs gestellt. Die zweite Antriebsvorrichtung kann allgemein als linearer oder quasilinearer Antrieb ausgebildet sein.

Eine erste Möglichkeit besteht darin, dass die zweite Antriebsvorrichtung die Linsenhalterung 16 der Schreiblinse 14 relativ zum Schreibstrahl 12 in der zweiten Bewegungsrichtung bewegt.

Eine zweite Möglichkeit besteht darin, dass die zweite Antriebsvorrichtung den Laser 6, die Kollimationsoptik 10 und die Linsenhalterung 16 der Schreiblinse 14 einschließlich des Rahmens 22 relativ zum Speichermedium 4 bewegt. Dazu wird die in Fig. 1 mit der gestrichelten Linie 32 dargestellte Einheit insgesamt senkrecht zur Zeichenebene bewegt.

Eine weitere Möglichkeit besteht darin, dass die zweite Antriebsvorrichtung das Speichermedium 4 selbst relativ zum Laser 6, zur Kollimationsoptik 10 und zur Schreiblinse 14 bewegt wird.

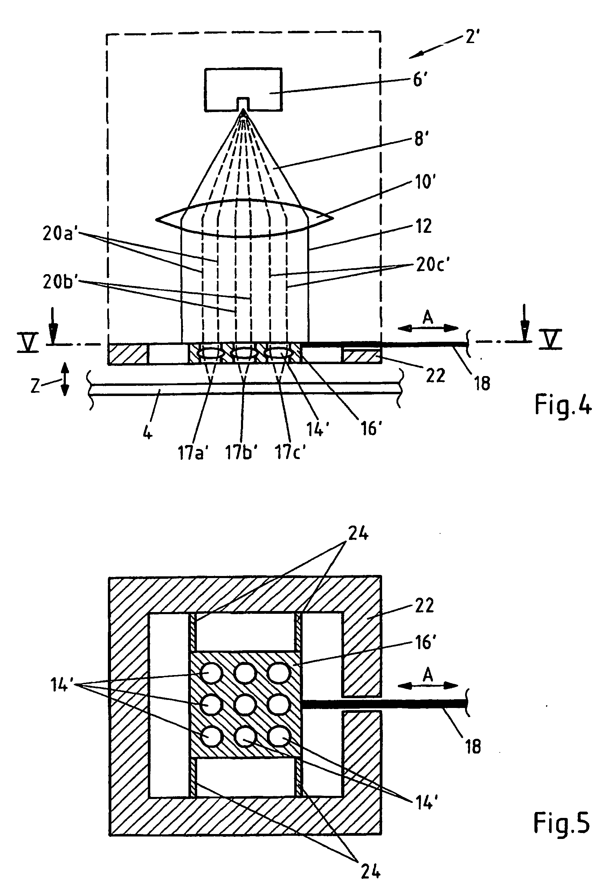

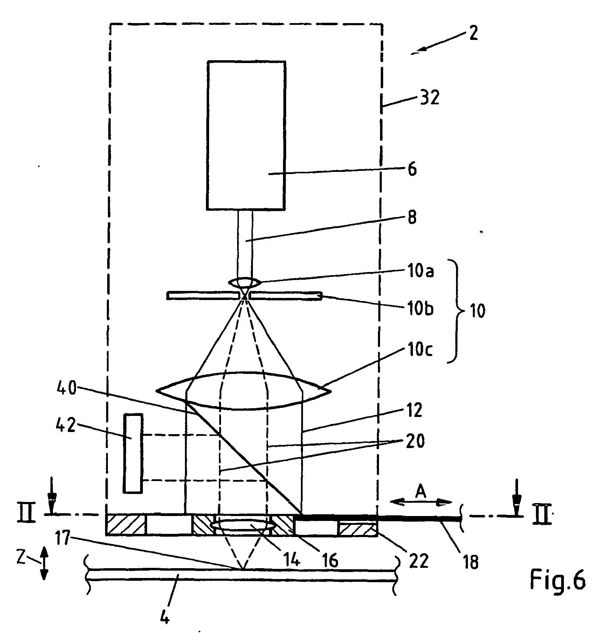

Eine weitere, an sich unabhängige Ausgestaltung eines erfindungsgemäßen Lithographen 2' ist in den Fig. 4 und 5 dargestellt. Dieser Lithograph 2' weist weitgehend die gleichen Bestandteile wie der in den Fig. 1 und 2 dargestellte Lithograph 2 auf. Daher sind gleiche Elemente mit übereinstimmenden Bezugszeichen versehen.

Der Lithograph 2' weist im Gegensatz zum Laser 6 in Fig. 1 eine Laserdiode 6' zum Erzeugen eines divergenten Laserstrahls 8', eine Kollimationslinse 10' zum Kollimieren des Schreibstrahls 12 mit einem vorgegebenen Strahlquerschnitt und mindestens eine Schreiblinse 14' zum Fokussieren des kollimierten Schreibstrahls 12 auf das zu beschreibende Speichermedium 4. Dabei ist die Schreiblinse 14' in einer Linsenhalterung 16' angeordnet.

Die Schreiblinse 14' ist als Mikrolinse ausgebildet, die eine Dimension im Bereich 1 mm aufweist, also in einem Bereich der Größe des zu schreibenden Hologramms. Somit verringert sich der Abstand zwischen der Schreiblinse 14' und dem Speichermedium 4, so dass die Abmessungen des Lithographen zumindest teilweise verringert werden kann. Außerdem wiegt die Schreiblinse 14' weniger als die größere Linse 14 gemäß den Fig. 1 und 2, so dass der Antrieb der Bewegung der Schreiblinse 14' daran angepasst werden kann.

Die Fig. 4 und 5 zeigen darüber hinaus, dass mehrere nebeneinander angeordnete Schreiblinsen 14' vorgesehen sind, wobei der Schreibstrahl 12 gleichzeitig die Schreiblinsen 14' ausleuchtet. Somit werden gleichzeitig die Teile 20a', 20b' und 20c' des aufgeweiteten Schreibstrahls 12 auf mehrere Fokuspunkte 17a', 17b', 17c' fokussiert, um jeweils bei ausreichender Intensität des Schreibstrahls 12 die optischen Eigenschaften des Materials des Speichermediums 4 zu verändern.

Wie insbesondere Fig. 5 zeigt, sind die Schreiblinsen 14' in einem 3x3 Array angeordnet. Selbstverständlich sind auch andere Arraygrößen möglich, beispielsweise 2x2 oder 4x4 oder weitere Größen. Durch eine Relativbewegung des Schreibstrahls zum Speichermedium können somit gleichzeitig mehrere digitale Hologramme geschrieben -werden.

Die oben in Bezug auf die Fig. 1 und 2 beschriebene Ausgestaltung der Erfindung bezüglich des Antriebes der Linsenhalterung 16 gilt auch in Bezug auf die in den Fig. 4 und 5 dargestellte Ausführungsform. Das bedeutet, dass das Array von Schreibmikrolinsen 14' zusammen mit der Halterung 16' im wesentlichen senkrecht zum Schreibstrahl 12 oszillierend bewegt werden kann, um in der ersten Bewegungsrichtung die zu beschreibenden Bereiche des Speichermediums zu erreichen. Ebenso können die verschiedenen Antriebsarten zur Bewegung entlang der zweiten Bewegungsrichtung angewendet werden, um für jede Schreibmikrolinse 14' einen vorgegebenen zweidimensionalen Bereich des Speichermediums 4 zu erfassen.

Ein weiteres Merkmal der zuvor beschriebenen Ausgestaltungen des Lithographen besteht darin, dass der Abstand zwischen dem Speichermedium 4 und der Schreiblinse 14 in Fig. 1 bzw. der Schreibmikrolinsen 14' in Fig. 4 variabel einstellbar ist. Dieses ist mit einem mit "Z" bezeichneten Doppelpfeil gekennzeichnet. Für ein Verstellen des Abstandes in z-Richtung sind in den Figuren nicht dargestellte Mittel vorgesehen. Dieses können jegliche linearen Verstellmittel sein, die motorisch oder per Hand angetrieben sein können. Durch ein Verstellen des Abstandes kann die Lage des Fokus im Speichermedium 4 in verschiedenen Tiefen angeordnet werden, ebenso ist eine Justierung des Fokus bei unterschiedlich dicken Speichermedien 4 möglich. Schließlich können mindestens zwei digitale Hologramme in verschiedenen Ebenen innerhalb des Speichermediums 4 eingeschrieben werden, um sogenannte Mehrschichthologramme zu erzeugen.

In Fig. 6 ist ein erfindungsgemäßes Mikroskop dargestellt, das in seinem Aufbau dem in Fig. 1 dargestellten Lithographen entspricht. Daher bezeichnen gleiche Bezugszeichen gleiche Bauteile wie im Zusammenhang mit Fig. 1 beschrieben worden sind, auch wenn im einzelne andere Bezeichnungen verwendet werden, die den Unterschied zwischen Schreiben und Abtasten bzw. Beobachten kennzeichnen.

Zusätzlich zum in Fig. 1 dargestellten Aufbau ist im Strahlengang des von der Oberfläche reflektierten Lichtes hinter, also oberhalb der Linse 14 eine Umlenkebene 40 angeordnet. Diese kann durch einen halbdurchlässigen Spiegel oder einen Strahlteiler verwirklicht sein und beeinflusst nicht oder nur unwesentlich den Beobachtungsstrahl.

Die Umlenkebene 40 lenkt den reflektierten Strahl seitlich, in Fig. 6 nach links ab, so dass dieser auf einen Photosensor 42 trifft, der die Intensität des reflektierten Lichtes misst.

Durch das Verändern der Position der Linse 14 relativ zum zu mikroskopierenden Objekt 4 wird dann die Oberfläche abgetastet bzw. beobachtet und punktweise die Reflektivität gemessen. Somit kann eine Abbildung der abgetasteten Oberfläche zusammengesetzt werden.

Wird nun der von der Lichtquelle 6 emittierte Lichtstrahl, der bei dem Mikroskop als Beobachtungsstrahl bezeichnet werden kann, mit im wesentlichen gleich starker Intensität erzeugt, so ist die gemessene Intensität des reflektierten Strahls ein Maß für die Reflektivität der abgetasteten Oberfläche.

## Patentansprüche

1. Lithographische Vorrichtung zum Herstellen digitaler Hologramme in einem Speichermedium (4),
- mit einer Lichtquelle (6,10) zum Erzeugen eines Schreibstrahls (12) mit einem vorgegebenen Strahlquerschnitt,
- mit einer Schreiblinse (14) zum Fokussieren des Schreibstrahls (12) auf das zu beschreibende Speichermedium (4), wobei die Apertur der Schreiblinse (14) kleiner als der Strahlquerschnitt des Schreibstrahls (12) ist, und wobei die Schreiblinse (14) in einer Linsenhalterung (16) angeordnet ist, und
- mit Antriebsmitteln zum zweidimensionalen Bewegen des Schreibstrahls (12) relativ zum Speichermedium (4),
- wobei die Antriebsmittel für das Erzeugen einer Scanbewegung in einer ersten Bewegungsrichtung im wesentlichen senkrecht zum Schreibstrahl (12) eine erste Antriebsvorrichtung (18) aufweist,
- wobei die Antriebsmittel für das Erzeugen einer Scanbewegung eine weite Antriebsvorrichtung zum Bewegen des Schreibstrahls relativ zum Speichermedium in einer zweiten Bewegungsrichtung quer zur ersten Bewegungsrichtung aufweist, und
- wobei die erste Antriebsvorrichtung eine Antriebsvorrichtung zur Erzeugung einer schnelleren Scanbewegung als die zweite Antriebsvorrichtung ist,
**dadurch gekennzeichnet,**
- **dass** die erste Antriebsvorrichtung (18) eine Antriebsvorrichtung zum Bewegen der Linsenhalterung (16) ist.

2. Vorrichtung nach spruch 1,
weiter **dadurch gekennzeichnet,**
**dass** die erste Antriebsvorrichtung als Linearmotor oder voice-Coil-Motor ausgebildet ist.

3. Vorrichtung nach Anspruch 1 oder 2,
weiter **dadurch gekennzeichnet**e
dass die Lagerung der Linsenhalterung (16) als Festkörperlager, Kugellager, Gleitlager, Luftlager oder Magnetlager ausgebildet ist.

4. Vorrichtung nach einem der Ansprüche 1 bis 3,
weiter **dadurch gekennzeichnet,**
**dass** die Linsenhalterung (16) linear gelagert ist und in einer Richtung resonant schwingt.

5. Vorrichtung nach einem der Ansprüche 1 bis 3
weiter **dadurch gekennzeichnet,**
**dass** die Linsenhalterung (16") drehgelagert ist und in einer Drehrichtung resonant schwingt.

6. Vorrichtung nach Anspruch 4 oder 5,
weiter **dadurch gekennzeichnet,**
**dass** die Linsenhalterung (16, 16'') mit einer Frequenz größer als 1 kHz schwingt.

7. Vorrichtung nach einem der Ansprüche 1 bis 6,
weiter **dadurch gekennzeichnet,**
**dass** die zweite Antriebsvorrichtung die Linsenhalterung (16, 16'') der Schreiblinse (14) relativ zum Schreibstrahl (12) bewegt.

8. Vorrichtung nach einem der Ansprüche 1 bis 6,
weiter **dadurch gekennzeichnet,**
**dass** die zweite Antriebsvorrichtung die Lichtquelle (6,10) und die Linsenhalterung (16, 16'') der Schreiblinse (14) relativ zum Speichermedium (4) bewegt.

9. Vorrichtung nach einem der Ansprüche 1 bis 6,
weiter **dadurch gekennzeichnet,**
**dass** die zweite Antriebsvorrichtung das Speichermedium (4) relativ zur Lichtquelle (6,10) und Linsenhalterung (16, 16") der Schreiblinse (14) bewegt.

10. Vorrichtung nach einem der Ansprüche 1 bis 9,
weiter **dadurch gekennzeichnet,**
**dass** die Schreiblinse (14') als Mikrolinse ausgebildet ist.

11. Vorrichtung nach Anspruch 10,
weiter **dadurch gekennzeichnet,**
**dass** mindestens zwei nebeneinander angeordnete Schreiblinsen (14') vorgesehen sind, wobei der Schreibstrahl (12) gleichzeitig die mindestens zwei Schreiblinsen (14') ausleuchtet.

12. Vorrichtung nach spruch 11,
weiter **dadurch gekennzeichnet,**
**dass** die Schreiblinsen (14') in einem Array angeordnet sind.

13. Vorrichtung nach einem der Ansprüche 1 bis 12,
weiter **dadurch gekennzeichnet,**
**dass** Mittel zum Verstellen des Abstandes zwischen dem Speichermedium (4) und der Schreiblinse (14, 14') vorgesehen sind.

14. Verfahren zum lithographischen Erzeugen digitaler Hologramme in einem Speichermedium mit einer lithographischen Vorrichtung nach einem der Ansprüche 1 bis 13,
- wobei ein Schreibstrahl (12) mit Hilfe einer Lichtquelle (6, 10) und einer Schreiblinse (14) auf das Speichermedium (4) fokussiert und mit Hilfe von Antriebsmitteln zweidimensional relativ zum Speichermedium bewegt wird,
- bei dem die Schreiblinse in einer ersten Bewegungsrichtung im wesentlichen senkrecht zur Ausbreitungsrichtung des Schreibstrahls relativ zum optischen Speichermedium bewegt wird,
- bei dem innerhalb des Bewegungsbereiches der Schreiblinse die Apertur der Schreiblinse vom Schreibstrahl im wesentlichen vollständig ausgeleuchtet wird und
- bei dem das Hologramm durch punktweises Einbringen von Strahlungsenergie geschrieben wird, wobei die Intensität des Schreibstrahls in Abhängigkeit von der Position des Schreibstrahls auf dem Speichermedium gesteuert wird.

15. Verfahren nach Anspruch 14,
bei dem die Schreiblinse in einer zweiten Bewegungsrichtung quer zur ersten Bewegungsrichtung relativ zum Speichermedium bewegt wird.

16. Verfahren nach Anspruch 14,
bei dem die Lichtquelle und die Schreiblinse relativ zum Speichermedium bewegt werden.

17. Verfahren nach Anspruch 14,
bei dem das Speichermedium relativ zur Lichtquelle und Schreiblinse bewegt wird.

18. Verfahren nach einem der Ansprüche 14 bis 17,
bei dem mit Hilfe des Schreibstrahls ein orthogonales Punktraster auf dem Speichermedium abgetastet wird.

19. Verfahren nach Anspruch 18,
bei dem die Relativbewegung zwischen Schreibstrahl und Speichermedium in der zweiten Bewegungsrichtung diskontinuierlich während der Bewegung der Schreiblinse in der ersten Bewegungsrichtung durchgeführt wird.

20. Verfahren nach Anspruch 19,
bei dem während der Bewegung des Schreibstrahls in der ersten Bewegungsrichtung entlang der zu beschreibenden Fläche des Speichermediums der Schreibstrahl nicht in der zweiten Bewegungsrichtung bewegt wird und
bei dem während der Bewegung des Schreibstrahls in der ersten Bewegungsrichtung entlang der nicht zu beschreibenden Fläche des Speichermediums der Schreibstrahl um einen Schritt quer zur ersten Bewegungsrichtung bewegt wird.

21. Verfahren nach Anspruch 18,
bei dem während der Bewegung des Schreibstrahls in der ersten Bewegungsrichtung der Schreibstrahl kontinuierlich in der zweiten Bewegungsrichtung bewegt wird.

22. Verfahren nach einem der Ansprüche 14 bis 21,
bei dem mit Hilfe von mindestens zwei nebeneinander angeordneten Schreiblinsen, die insbesondere in Form von Mikrolinsen ausgebildet sind, gleichzeitig Hologramme auf dem Speichermedium geschrieben werden.

23. Verfahren nach einem der Ansprüche 14 bis 22,
bei dem der Abstand zwischen der Schreiblinse bzw. Schreibmikrolinse und dem Speichermedium für ein Schreiben in verschiedenen Tiefen innerhalb des Speichermediums eingestellt wird.

24. Mikroskop zum Abtasten eines Objektes (4),
- mit einer Lichtquelle (6,10) zum Erzeugen eines Beobachtungsstrahls (12) mit einem vorgegebenen Strahlquerschnitt,
- mit einer Linse (14) zum Fokussieren des Beobachtungsstrahls (12) auf die Oberfläche des Objekts (4), wobei die Apertur der Linse (14) kleiner als der Strahlquerschnitt des Beobachtungsstrahls (12) ist, und wobei die Linse (14) in einer Linsenhalterung (16) angeordnet ist, und
- mit Antriebsmittel zum zweidimensionalen Bewegen des Beobachtungsstrahls (12) relativ zum Objekt (4),
- wobei die Antriebsmittel für das Erzeugen einer Scanbewegung in einer ersten Bewegungsrichtung im wesentlichen senkrecht zum Schreibstrahl (12) eine erste Antriebsvorrichtung (18) aufweist,
- wobei die Antriebsmittel für das Erzeugen einer Scanbewegung eine zweite Antriebsvorrichtung zum Bewegen des Schreibstrahls relativ zum Speichermedium in einer zweiten Bewegungsrichtung quer zur ersten Bewegungsrichtung aufweist, und
- wobei die erste Antriebsvorrichtung eine Antriebsvorrichtung zur Erzeugung einer schnelleren Scanbewegung als die zweite Antriebsvorrichtung ist, **dadurch gekennzeichnet,**
- **dass** die erste Antriebsvorrichtung (18) eine Antriebsvorrichtung zum Bewegen der Linsenhalterung (16) ist.

25. Mikroskop nach Anspruch 24 mit dem weiter kennzeichnenden Merkmal bzw. mit den weiter kennzeichnenden Merkmalen eines der Ansprüche 2 bis 13.

## Claims

1. Lithographic device for producing digital holograms in a storage medium (4),
- having a light source (6, 10) for producing a write beam (12) with a predefined beam cross section,
- having a writing lens (14) for focusing the write beam (12) onto the storage medium (4) to be written, the aperture of the writing lens (14) being smaller than the beam cross section of the write beam (12), and the writing lens (14) being arranged in a lens holder (16), and
- having drive means for the two-dimensional movement of the write beam (12) relative to the storage medium (4),
- the drive means for producing a scanning movement in a first direction of movement substantially at right angles to the write beam (12) having a first drive device (18),
- the drive means for producing a scanning movement having a second drive device for moving the write beam relative to the storage medium in a second direction of movement transversely with respect to the first direction of movement, and
- the first drive device being a drive device for producing a faster scanning movement than the second drive device,
**characterized in that**
- the first drive device (18) is a drive device for moving the lens holder (16).

2. Device according to Claim 1, further **characterized in that** the first drive device is formed as a linear motor or as a voice coil motor.

3. Device according to Claim 1 or 2, further **characterized in that** the mounting of the lens holder (16) is formed as solid-state bearings, ball bearings, sliding bearings, air bearings or magnetic bearings.

4. Device according to one of Claims 1 to 3, further **characterized in that** the lens holder (16) is linearly mounted and oscillates resonantly in one direction.

5. Device according to one of Claims 1 to 3, further **characterized in that** the lens holder (16") is rotationally mounted and oscillates resonantly in one rotational direction.

6. Device according to Claim 4 or 5, further **characterized in that** the lens holder (16, 16") oscillates at a frequency greater than 1 kHz.

7. Device according to one of Claims 1 to 6, further **characterized in that** the second drive device moves the lens holder (16, 16'') of the writing lens (14) relative to the write beam (12).

8. Device according to one of Claims 1 to 6, further **characterized in that** the second drive device moves the light source (6, 10) and the lens holder (16, 16") of the writing lens (14) relative to the storage medium (4).

9. Device according to one of Claims 1 to 6, further **characterized in that** the second drive device moves the storage medium (4) relative to the light source (6, 10) and the lens holder (16, 16") of the writing lens (14).

10. Device according to one of Claims 1 to 9, further **characterized in that** the writing lens (14') is formed as a micro lens.

11. Device according to Claim 10, further **characterized in that** at least two writing lenses (14') arranged beside each other are provided, the write beam (12) illuminating the at least two writing lenses (14') simultaneously.

12. Device according to Claim 11, further **characterized in that** the writing lenses (14') are arranged in an array.

13. Device according to one of Claims 1 to 12, further **characterized in that** means are provided for adjusting the distance between the storage medium (4) and the writing lens (14, 14').

14. Method for the lithographic production of digital holograms in a storage medium with a lithographic device according to one of Claims 1 to 13,
- a write beam (12) being focused onto the storage medium (4) with the aid of a light source (6, 10) and a writing lens (14) and being moved two-dimensionally relative to the storage medium with the aid of drive means,
- in which the writing lens is moved relative to the optical storage medium in a first direction of movement substantially at right angles to the propagation direction of the write beam,
- in which, within the range of movement of the writing lens, the aperture of the writing lens is illuminated substantially completely by the write beam, and
- in which the hologram is written by introducing radiation energy point by point, the intensity of the write beam being controlled as a function of the position of the write beam on the storage medium.

15. Method according to Claim 14, in which the writing lens is moved relative to the storage medium in a second direction of movement transversely with respect to the first direction of movement.

16. Method according to Claim 14, in which the light source and the writing lens are moved relative to the storage medium.

17. Method according to Claim 14, in which the storage medium is moved relative to the light source and writing lens.

18. Method according to one of Claims 14 to 17, in which an orthogonal point pattern on the storage medium is scanned with the aid of the write beam.

19. Method according to Claim 18, in which the relative movement between write beam and storage medium in the second direction of movement is carried out discontinuously during the movement of the writing lens in the first direction of movement.

20. Method according to Claim 19, in which, during the movement of the write beam in the first direction of movement along the area of the storage medium to be written, the write beam is not moved in the second direction of movement and
in which, during the movement of the write beam in the first direction of movement along the area of the storage medium not to be written, the write beam is moved by one step transversely with respect to the first direction of movement.

21. Method according to Claim 18, in which, during the movement of the write beam in the first direction of movement, the write beam is moved continuously in the second direction of movement.

22. Method according to one of Claims 14 to 21, in which, with the aid of at least two writing lenses which are arranged beside each other and in particular are designed in the form of micro lenses, holograms are written on the storage medium simultaneously.

23. Method according to one of Claims 14 to 22, in which the distance between the writing lens or writing micro lens and the storage medium is set to write at various depths within the storage medium.

24. Microscope for scanning an object (4),
- having a light source (6, 10) for producing an observation beam (12) with a predefined beam cross section,
- having a lens (14) for focusing the observation beam (12) onto the surface of the object (4), the aperture of the lens (14) being smaller than the beam cross section of the observation beam (12), and the lens (14) being arranged in a lens holder (16), and
- having drive means for the two-dimensional movement of the observation beam (12) relative to the object (4),
- the drive means for producing a scanning movement in a first direction of movement substantially at right angles to the write beam (12) having a first drive device (18),
- the drive means for producing a scanning movement having a second drive device for moving the write beam relative to the storage medium in a second direction of movement transversely with respect to the first direction of movement, and
- the first drive device being a drive device for producing a faster scanning movement than the second drive device,
**characterized in that**
- the first drive device (18) is a drive device for moving the lens holder (16).

25. Microscope according to Claim 24, having the further characterizing feature or having the further characterizing features of one of Claims 2 to 13.

## Revendications

1. Dispositif lithographique pour la réalisation d'hologrammes numériques dans un support d'enregistrement (4), comprenant une source de lumière (6, 10) pour générer un rayon d'écriture (12) ayant une section transversale de rayon donnée, une lentille d'écriture (14) pour concentrer le rayon d'écriture (12) sur le support d'enregistrement (4) à écrire, l'ouverture de la lentille d'écriture (14) étant plus petite que la section transversale du rayon d'écriture (12), et la lentille d'écriture (14) étant disposée dans une monture de lentille (16), et des moyens d'entraînement pour le déplacement bidimensionnel du rayon d'écriture (12) par rapport au support d'enregistrement (4), le moyen d'entraînement pour produire un mouvement de balayage dans une première direction de déplacement essentiellement perpendiculaire au rayon d'écriture (12) présentant un premier dispositif d'entraînement (18), le moyen d'entraînement pour produire un mouvement de balayage présentant un deuxième dispositif d'entraînement en vue de déplacer le rayon d'écriture par rapport au support d'enregistrement dans une deuxième direction de déplacement transversale à la première direction de déplacement et le premier dispositif d'entraînement étant un dispositif d'entraînement destiné à produire un mouvement de balayage plus rapide que le deuxième dispositif d'entraînement, **caractérisé en ce que** le premier dispositif d'entraînement (18) est un dispositif d'entraînement destiné à déplacer la monture de lentille (16) .

2. Dispositif selon la revendication 1, également **caractérisé en ce que** le premier dispositif d'entraînement est réalisé sous la forme d'un moteur linéaire ou d'un moteur à bobine mobile.

3. Dispositif selon la revendication 1 ou 2, également **caractérisé en ce que** le support de la monture de lentille (16) est réalisé sous la forme d'un palier fixe, d'un roulement à billes, d'un palier à glissement, d'un coussin d'air ou d'un palier magnétique.

4. Dispositif selon l'une des revendications 1 à 3, également **caractérisé en ce que** la monture de lentille (16) est supportée linéairement et oscille avec résonance dans une direction.

5. Dispositif selon l'une des revendications 1 à 3, également **caractérisé en ce que** la monture de lentille (16") est supportée de manière pivotante et oscille avec résonance dans un sens de rotation.

6. Dispositif selon la revendication 4 ou 5, également **caractérisé en ce que** la monture de lentille (16, 16") oscille une fréquence supérieure à 1 kHz.

7. Dispositif selon l'une des revendications 1 à 6, également **caractérisé en ce que** le deuxième dispositif d'entraînement déplace la monture de lentille (16, 16") de la lentille d'écriture (14) par rapport au rayon d'écriture (12).

8. Dispositif selon l'une des revendications 1 à 6, également **caractérisé en ce que** le deuxième dispositif d'entraînement déplace la source de lumière (6, 10) et la monture de lentille (16, 16") de la lentille d'écriture (14) par rapport au support d'enregistrement (4).

9. Dispositif selon l'une des revendications 1 à 6, également **caractérisé en ce que** le deuxième dispositif d'entraînement déplace le support d'enregistrement (4) par rapport à la source de lumière (6, 10) et à la monture de lentille (16, 16") de la lentille d'écriture (14).

10. Dispositif selon l'une des revendications 1 à 9, également **caractérisé en ce que** la lentille d'écriture (14') est réalisée sous la forme d'une microlentille.

11. Dispositif selon la revendication 10, également **caractérisé en ce qu'**au moins deux lentilles d'écriture (14') disposées l'une à côté de l'autre sont prévues, le rayon d'écriture (12) éclairant simultanément les au moins deux lentilles d'écriture (14') .

12. Dispositif selon la revendication 11, également **caractérisé en ce que** les lentilles d'écriture (14') sont disposées dans un réseau.

13. Dispositif selon l'une des revendications 1 à 12, également **caractérisé en ce que** des moyens de réglage de l'écart entre le support d'enregistrement (4) et la lentille d'écriture (14, 14') sont prévus.

14. Procédé pour la réalisation lithographique d'hologrammes numériques dans un support d'enregistrement comprenant un dispositif lithographique selon l'une des revendications 1 à 13, un rayon d'écriture (12) étant concentré sur le support d'enregistrement (4) à l'aide d'une source de lumière (6, 10) et d'une lentille d'écriture (14) et déplacé dans deux dimensions par rapport au support d'enregistrement à l'aide de moyens d'entraînement, la lentille d'écriture étant déplacée par rapport au support d'enregistrement optique dans une première direction de déplacement essentiellement perpendiculaire au sens de propagation du rayon d'écriture, l'ouverture de la lentille d'écriture étant pour l'essentiel entièrement éclairée par le rayon d'écriture au sein de la plage de déplacement de la lentille d'écriture et l'hologramme étant écrit par l'application ponctuelle d'énergie de rayonnement, l'intensité du rayon d'écriture étant commandée en fonction de la position du rayon d'écriture sur le support d'enregistrement.

15. Procédé selon la revendication 14, la lentille d'écriture étant déplacée par rapport au support d'enregistrement dans une deuxième direction de déplacement transversale à la première direction de déplacement.

16. Procédé selon la revendication 14, la source de lumière et la lentille d'écriture étant déplacées par rapport au support d'enregistrement.

17. Procédé selon la revendication 14, le support d'enregistrement étant déplacé par rapport à la source de lumière et à la lentille d'écriture.

18. Procédé selon l'une des revendications 14 à 17, une grille de points orthogonale étant balayée sur le support d'enregistrement à l'aide du rayon d'écriture.

19. Procédé selon la revendication 18, le mouvement relatif entre le rayon d'écriture et le support d'enregistrement dans la deuxième direction de déplacement étant discontinu pendant que se déroule le mouvement de la lentille d'écriture dans la première direction de déplacement.

20. Procédé selon la revendication 19, le rayon d'écriture n'étant pas déplacé dans la deuxième direction de déplacement pendant le mouvement du rayon d'écriture dans la première direction de déplacement le long de la surface à écrire du support d'enregistrement et le rayon d'écriture étant déplacé d'un pas transversalement à la première direction de déplacement pendant le mouvement du rayon d'écriture dans la première direction de déplacement le long de la surface qui n'est pas à écrire du support d'enregistrement.

21. Procédé selon la revendication 18, le rayon d'écriture étant continuellement déplacé dans la deuxième direction de déplacement pendant le mouvement du rayon d'écriture dans la première direction de déplacement.

22. Procédé selon l'une des revendications 14 à 21, des hologrammes étant écrits simultanément sur le support d'enregistrement à l'aide d'au moins deux lentilles d'écriture disposées l'une à côté de l'autre, lesquelles sont notamment réalisées sous la forme de microlentilles.

23. Procédé selon l'une des revendications 14 à 22, l'écart entre la lentille d'écriture ou la microlentille d'écriture et le support d'enregistrement étant réglé pour une écriture à différentes profondeurs à l'intérieur du support d'enregistrement.

24. Microscope pour balayer un objet (4), comprenant une source de lumière (6, 10) pour générer un rayon d'observation (12) ayant une section transversale de rayon donnée, une lentille (14) pour concentrer le rayon d'observation (12) sur la surface de l'objet (4), l'ouverture de la lentille (14) étant plus petite que la section transversale du rayon d'observation (12), et la lentille (14) étant disposée dans une monture de lentille (16), et des moyens d'entraînement pour le déplacement bidimensionnel du rayon d'observation (12) par rapport à l'objet (4), le moyen d'entraînement pour produire un mouvement de balayage dans une première direction de déplacement essentiellement perpendiculaire au rayon d'écriture (12) présentant un premier dispositif d'entraînement (18), le moyen d'entraînement pour produire un mouvement de balayage présentant un deuxième dispositif d'entraînement en vue de déplacer le rayon d'écriture par rapport au support d'enregistrement dans une deuxième direction de déplacement transversale à la première direction de déplacement et le premier dispositif d'entraînement étant un dispositif d'entraînement destiné à produire un mouvement de balayage plus rapide que le deuxième dispositif d'entraînement, **caractérisé en ce que** le premier dispositif d'entraînement (18) est un dispositif d'entraînement destiné à déplacer la monture de lentille (16).

25. Microscope selon la revendication 24, possédant l'autre caractéristique caractérisante ou les autres caractéristiques caractérisantes de l'une des revendications 2 à 13.
